# EUROPEAN PATENT APPLICATION

(11) **EP 2 563 104 A1**
(43) Date of publication of application: **27.02.2013**
(21) Application number: 11771781.9
(22) Date of filing: 26.01.2011
(51) Int. Cl.: H05K 3/00, H01F 27/32

(54) **SUBSTRATE AND SUBSTRATE PRODUCTION METHOD**

(30) Priority: 20.04.2010 JP 2010096610
(71) Applicant: Furukawa Electric Co., Ltd., Chiyoda-ku Tokyo 100-8322 (JP); Furukawa Automotive Systems Inc., Inukami-gun, Shiga 522-0242 (JP)
(72) Inventor: HARA, Toshitaka, Tokyo 100-8322 (JP); HASHIMOTO, Kyosuke, Tokyo 100-8322 (JP); TORATANI, Tomoaki, Tokyo 100-8322 (JP); ABE, Kyutaro, Tokyo 100-8322 (JP); FUKAI, Hiroyuki, Tokyo 100-8322 (JP)
(74) Representative: Strehl Schübel-Hopf & Partner
(86) International application number: PCT/JP2011/051411
(87) International publication number: WO 2011/132441

(57) **Abstract**

A substrate 1 has a coil 5 that is a choke coil part and, for example, is used for controlling a motor. At the substrate 1, an electronic component mounting part 9 is formed such that a circuit conductor therein is to be exposed to outside. A portion other than an externally connected portion such as the electronic mounting part 9 is covered with substrate-forming resin to form an injection molded circuit board 3. The coil 5 arranged at the substrate 1 (the injection molded circuit board 3) is provided for smoothing current inputted from outside. A core part 7 is formed at the coil 5 by core-forming resin such that the coil part 7 covers at least a center core part 6 of the coil 5.

## Description

### TECHNICAL FIELD

The present invention relates to a substrate for controlling a motor with a coil part, which is used for such as an automobile, and relates to a method of manufacturing the same.

The main type of a pump for cooling-water circulation, which is mounted on a hybrid car etc., is an electromotive one so that it may not be influenced by the number of revolution of an engine. For controlling a motor used for the water pump etc., a driver circuit in which a circuit for controlling a motor is incorporated is used.

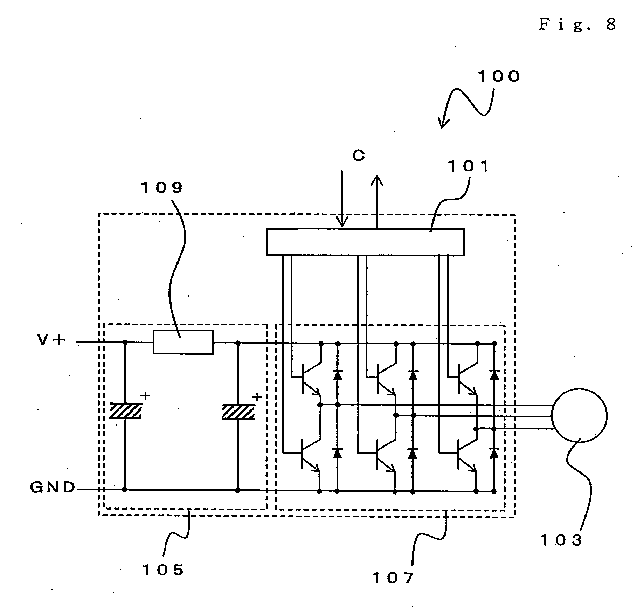

Fig. 8 illustrates an example of such a driver circuit 100. A motor 103 is, for example, a three-phase brushless motor. The direct-current supplied from a power source is smoothed by a power smoothing part 105 including such as a choke coil 109. Based on a control signal (C) from an engine computer, a motor drive control circuit 101 calculates, and further based on the calculation, the motor 103 is controlled by controlling a switching element part 107 including a switching element such as a transistor. As a choke coil, a common mode choke coil may be used.

Various devices for controlling such a motor have been developed, for example, they are described in the patent document 1 and patent document 2.

### PRIOR ART DOCUMENT(S)

### PATENT DOCUMENT(S)

[Patent document 1] Japanese Patent Application Laid-open No. H11-98890 A
[Patent document 2] Japanese Patent Application Laid-open No. 2001-186789 A

### SUMMARY OF INVENTION

### TECHNICAL PROBLEM TO BE SOLVED

On the other hand, at the driver circuit 100, a circuit for control and a circuit for drive are configured separately, and then connected with each other by a cable etc. for use. This is because circuits at a general printed board cannot resist high current. For this reason, for example, there is a case where a choke coil 109 used in the power smoothing part 105 is configured as another body independent of a printed circuit board. Additionally, a ferrite core (a core part) is formed in the choke coil 109. Therefore, it is necessary to attach the ferrite core to the choke coil 109.

However, in such a configuration, since a device tends to become larger and each component needs to be connected or fixed, high productivity performance is not available. Alternatively, as a substrate usable under a high current condition, an injection molded circuit board in which a conductor part is formed by pressing and an insulating part is formed by injection molding has been known. However, even in this configuration, a step of fixing a ferrite core cannot be omitted.

The present invention has been made in view of such problems. The object of the present invention is to provide a substrate for controlling a motor, which is usable under a high current condition, which is configured to be one body, and which does not need a step of fixing a ferrite core, and also to provide a method of manufacturing the same.

### SOLUTION TO PROBLEM

In order to achieve the above-mentioned object, a first aspect of the present invention provides a substrate comprising an injection molded circuit board having a coil part formed with a circuit conductor of which a surface is injection molded by substrate-forming resin; and a core part being formed at least at a center core part of the coil part by core-forming resin having magnetic filler.

It is desirable for a melting temperature of the substrate-forming resin to be higher than a melting temperature of the core-forming resin.

It is desirable for the magnetic filler to be insulating. The coil part of the injection molded circuit board may have a case part being formed by the substrate-forming resin so as to surround the center core part of the coil part and the core-forming resin may be injected inside of the case part to form the core part.

A connecting terminal that is electronically connectable to outside may be arranged to be protruded at a part of the substrate. The substrate may have a switching element and a circuit, for controlling a motor, that is formed with the circuit conductor.

According to the first aspect of the invention, since the coil part is formed with a circuit conductor and the substrate is formed by injection molding, the substrate that enables to resist high current can be formed to be one body with the coil. Additionally, since core-forming resin having magnetic filler is injected toward the center core part of the coil part, the core part can be also formed to be one body with them. Accordingly, it is not necessary to fix the core part separately.

Also according to the first aspect of the invention, since a melting temperature of core-forming resin is lower than that of substrate-forming resin, substrate-forming resin is not melted at the time of injection of core-forming resin.

Also according to the first aspect of the invention, as long as magnetic filler is an insulator, a surface of an electronic component may be covered with core-forming resin having magnetic filler in order to prevent noise generated at an electronic component etc. other than the coil part. Additionally, the coil part may be directly covered with core-forming resin but not with substrate-forming resin.

Also according to the first aspect of the invention, a connector or a cable becomes unnecessary since an external component such as a motor can be connected with the substrate by direct welding, soldering, etc. in a configuration that a terminal for connecting with outside is arranged at a part of the substrate so as to be protruded.

A second aspect of the invention relates to a method of manufacturing a substrate comprising the steps of joining circuit materials that are conductors to form a circuit conductor having a coil part, injecting substrate-forming resin toward a surface of the circuit conductor to mold an injection molded circuit board, and injecting core-forming resin that has magnetic filler and that has a lower melting point than a melting point of the substrate-forming resin to mold a core part at least at a center core part of the coil part.

The coil part of the injection molded circuit board may have a case part being formed so as to surround all around the coil part and the core-forming resin may be injected inside of the case part to form a core.

The case part may be injection molded to be one body with the injection molded circuit board by the substrate-forming resin.

According to the second aspect of the invention, it is able to provide a method of manufacturing a substrate which is easily manufactured, which is usable under a high current condition, and which does not need a step of fixing a core part of a coil.

Particularly, in a configuration with a case part that is formed at a portion to be injection molded by core-forming resin, it can be prevented that the core part happens to rotate against the substrate. Also, in a configuration including a case part that is formed to be one body with the injection molded circuit board, it is able to obtain a substrate having a high manufacturability.

### ADVANTAGEOUS EFFECTS OF INVENTION

According to the present invention, it is able to provide a substrate for controlling a motor, which is usable under a high current condition, which is configured to be one body, and which does not need a step of fixing a ferrite core, and also to provide a method of manufacturing the same.

### BRIEF DESCRIPTION OF THE DRAWINGS

[Fig. 1] Fig. 1 illustrates a substrate 1, particularly Fig. 1 (a) is an exploded perspective view and Fig. 1 (b) is an assembly perspective view.
[Fig. 2] Fig. 2 is a top view of a substrate 1.
[Fig. 3] Fig. 3 is a sectional view of a substrate 1, particularly, is an A-A line sectional view of Fig. 2.
[Fig. 4] Fig. 4 is an exploded conceptual view of a circuit material.
[Fig. 5] Fig. 5 (a) is a conceptual view of a circuit conductor 15 as well as is a transparent view of an injection molded circuit board, and Fig. 5 (b) illustrates a condition in which a core part is injection molded.
[Fig. 6] Fig. 6 is a perspective view of a substrate 20, particularly Fig. 6 (a) illustrates a condition before a core part is injection molded and Fig. 6 (b) illustrates a condition after a core part is injection molded.
[Fig. 7] Fig. 7 is a B-B line sectional view of Fig. 6.
[Fig. 8] Fig. 8 illustrates a conventional driver circuit 100 for driving a motor.

### DETAILED DESCRIPTION OF EMBODIMENTS

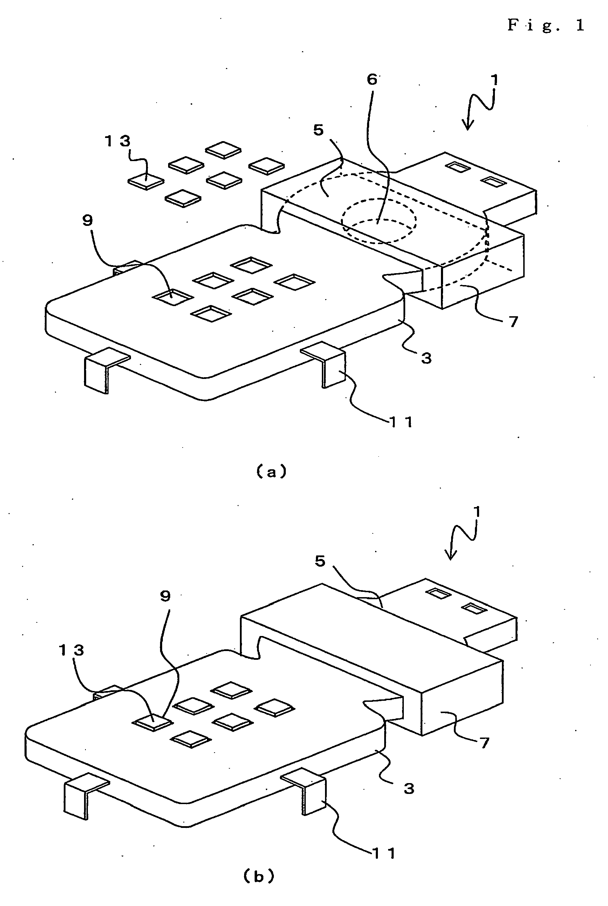

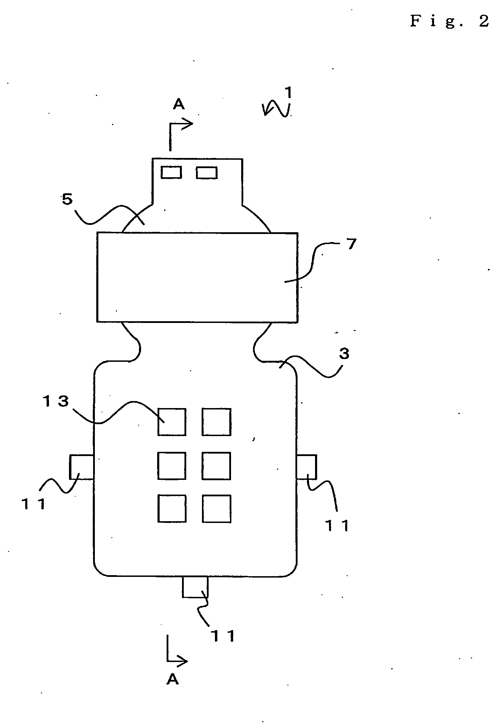

Hereinafter, embodiments of the present invention will be described with reference to the accompanying drawings. Fig. 1 and Fig. 2 illustrate a substrate 1. Fig. 1 (a) is an exploded perspective view, Fig. 1 (b) is an assembly perspective view, and Fig. 2 is a top view. The substrate 1 has a coil 5 that is a choke coil part and, for example, is used for controlling a motor. At the substrate 1, an electronic component mounting part 9 is formed such that a circuit conductor therein is to be exposed to outside. A portion other than an externally connected portion such as the electronic mounting part 9 is covered with substrate-forming resin to form an injection molded circuit board 3. The injection molded circuit board 3 installs an electronic component 13 etc. thereon.

The coil 5 arranged at the substrate 1 (the injection molded circuit board 3) is provided for smoothing current inputted from outside. The electronic component mounting part 9 is a portion for installing the electronic component 13 etc. thereon, and the electronic component 13 is electronically connected to the substrate 1 (the injection molded circuit board 3).

A substrate according to the present invention is not restricted to the ones illustrated in the drawings, but the present invention is applicable to any substrates having a coil part, into which high current flows. Hence, the formations and shapes of a substrate are not restricted to the ones illustrated in the drawings, but other components etc. may be arranged thereon suitably, or other formations and shapes may be employed suitably.

A core part 7 is formed at the coil 5 by core-forming resin such that the coil part 7 covers (fills in) at least a center core part 6 of the coil 5. As illustrated, the core part 7 may cover the entire part of the coil 5 as long as the core part 7 is formed at the center core part 6 of the coil 5. In this case, the width of the core part 7 is longer than that of the coil 5 (the coil part in a condition where the substrate-forming resin covers there), and side surfaces of the core part 7 are formed continuously over a top and bottom surfaces of the core part 7.

On a side of the substrate 1, a connecting terminal 11 is provided to be protruded. The connecting terminal 11 is a portion arranged to be electrically connected with an external component etc., hence, it is electrically connected with a circuit inside. The connecting terminals, for example, may be formed in three places, so that they may be connected with each terminal of a three-phase motor.

The connecting terminal 11, for example, is L-shaped as illustrated, and is arranged to being one body with a circuit conductor inside of the injection molded circuit board or is joined by welding to be exposed to outside of a resin-covered portion. The connecting terminal 11 can be connected to other components of an object to be connected, by direct welding or soldering. Accordingly, a connector or a cable becomes unnecessary and thus the number of components can be reduced. In addition, the shape of the connecting terminal 11 is not restricted to the illustrated one as long as a conductor part is exposed from resin of the substrate 1.

Both the injection molded circuit board 3 and the core part 7 are formed by injection molding. As substrate-forming resin, which forms the injection molded circuit board 3, the ones which are insulating and capable of being injected for molding are good for use, for example, a liquid crystal polymer, poly phenylene sulfide, polybutylene terephthalate, poly ether sulphone, polyether ether ketone, poly phthalamide, etc. can be used. Additionally, epoxy resin can be also used as thermoset resin.

The core part 7 is formed by core-forming resin containing magnetic filler. Although, as a base material for core-forming resin, resin that is similar to substrate-forming resin can be used, it is more desirable to select the one having a lower melting point than that of substrate-forming resin in order to prevent substrate-forming resin to be melted at the time of injection molding of core-forming resin. This is because core-forming resin is injection molded toward the injection molded circuit board after injection molding of substrate-forming circuit board. As substrate-forming resin, for example, poly phenylene sulfide can be used, and as core-forming resin, polybutylene terephthalate can be used.

As magnetic filler, soft ferrite, hard ferrite, Fe and Fe alloy, Co amorphous, etc. can be used. It is desirable for magnetic filler to be insulating, and in this case, "MAGMEL GC®" of Kobe Steel, Ltd. (insulating iron powder, of which a surface includes an inorganic insulating film having high heat resistance and high insulation) can be used.

As the electronic component 13, for example, a switching element of a transistor, etc. is applicable, and also, a capacitor or a diode may be applicable. Furthermore, as the electronic component 13, a printed circuit board installing a CPU or a ceramic condenser beforehand is applicable as well.

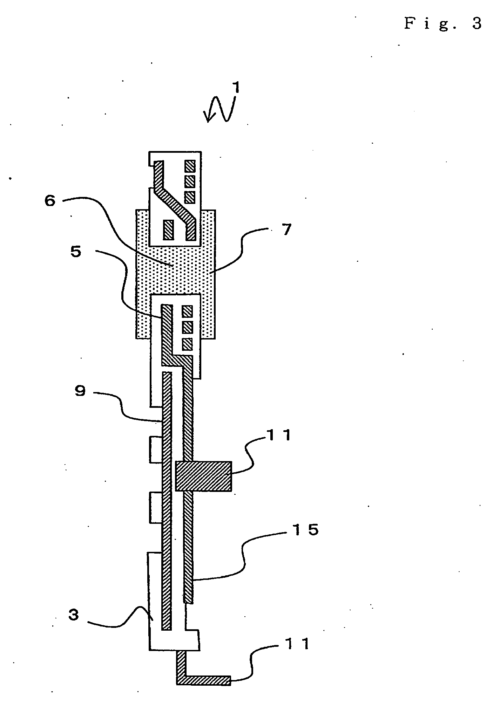

Fig. 3 is an A-A line sectional view of Fig. 2 and is a conceptual view illustrating the circuit conductor 15 arranged inside of the substrate 1. The circuit conductor 15 is a circuit formed with a plurality of conductors that are jointed with each other. In the following drawings, a circuit conductor is illustrated conceptually and almost all structural elements are illustrated in plane-shaped, in order to make it easy to explain herein. Therefore and needless to say, the circuit conductor can employ more detailed shape or structure if necessary to configure a circuit. As for the details of the circuit conductor 15, it will be described later.

At the substrate 1, a plurality of circuit materials (conductors which constitute the circuit conductor 15) are formed in layers, and each of the circuit materials are joined by welding or joined interposing such as an insulation material. At the substrate 1, the core part 7 is formed at the injection molded circuit board 3 having the coil 5. As mentioned above, the injection molded circuit board 3 is formed such that the conductor part of the circuit conductor 15 is exposed at the predetermined position and other portion is covered with substrate-forming resin.

The coil 5 has a conductor arranged in circle, and core-forming resin is injected to form the core part 7 so as to penetrate through a hole of the center (the center core part 6). As long as magnetic filler contained in core-forming resin is an insulation material, the core part 7 is not necessarily formed in an upper layer of the coil 5 covered with substrate-forming resin, but core-forming resin may be directly injected toward the coil 5 that is a circuit conductor to cover. Hence, in this case, at the injection molded circuit board 3, the coil 5 is not covered with substrate-forming resin, but the entire part of the coil 5 is covered with core-forming resin.

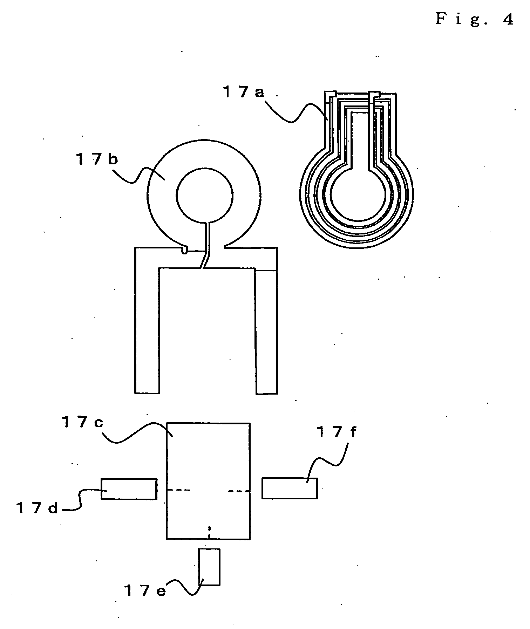

Next, a method of manufacturing the substrate 1 will be described hereinafter. Firstly, as illustrated in Fig. 4, circuit materials, which are conductors for a copper plate, etc. are cut off by pressing, and they are bended to form in desired shape. The circuit materials 17a-17f are materials for constituting the circuit conductor 15. As mentioned above, the shape of the circuit material illustrated in the drawing is a conceptual one, therefore, for example, the circuit material 17c is not necessarily in tabular shape, but it may be formed in the shape which constitutes a circuit by pressing (or a plurality of materials). Sn plating etc. may be given to a copper plate if appropriate. Secondly, a plurality of circuit materials 17a-17f are joined by welding or joined interposing an insulating member to form a circuit conductor. The circuit conductor may be formed not only in a plane but also can be formed in layers with a plurality of layers.

As the circuit materials 17a-17f, for example, a copper plate being more than 400µm thick is used. This is because when it is less than 400µm thick, it cannot resist high current, and moreover, it might be deformed by pressure of resin caused at the time of injection molding. It is more desirable for thickness of a conductor circuit material to be 400µm to 1000µm. This is because when it is too thick, cost and weight increases, which causes difficulty to manufacture more compact substrate.

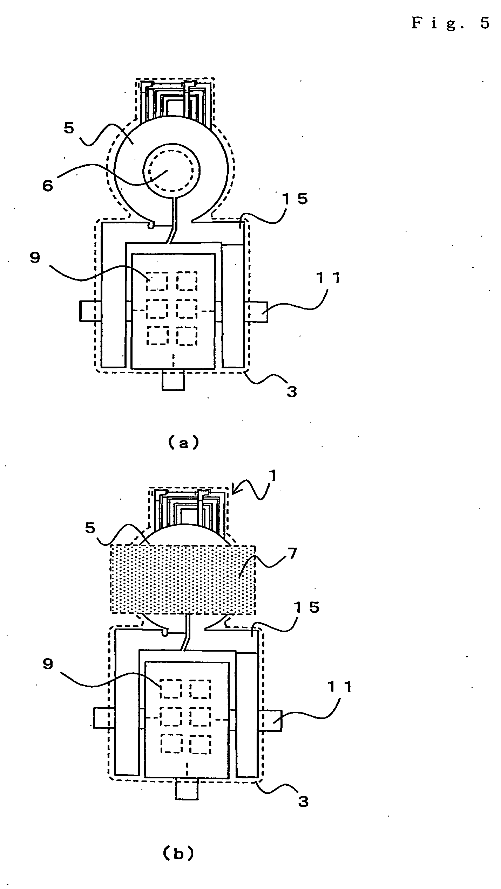

Fig. 5 (a) illustrates a condition in which substrate-forming resin is injected to the circuit materials 17a-17f that have been joined with each other. The circuit materials 17a-17f are joined with each other to form the circuit conductor 15, and the circuit conductor 15 is fixed to an injection molding mold with a pin etc. in a predetermined position to injection mold with substrate-forming resin. In this process, a portion other than an exposed part of the conductor is covered with substrate-forming resin, and also, resin is injected between layers of each of the circuit materials. In this way, the injection molded circuit board 3 is formed.

Next, the injection molded circuit board is set up in the injection molding mold for core-forming, and as illustrated in Fig. 5 (b), the core part 7 is formed by injection molding so that the center core part 6 of the coil 5 may be covered.

Next, the electronic component 13 is installed on the electronic component mounting part 9 to electronically connect with each other. In order to connect an electronic component, etc., for example, soldering or wire bonding can be employed. The substrate 1 is formed in the process mentioned above. After the injection molded circuit board 3 is formed, the electronic component 13 may be installed before the core part is formed, and as the last step, the core part 7 may be injection molded. As long as magnetic filler contained in core-forming resin is an insulating material, core-forming resin that constitutes the core part 7 can be injected so as to cover an electronic component. In this case, it is able to prevent such as generation of noise since core-forming resin containing magnetic filler is provided so as to cover an electronic component or a circuit part which produces noise.

As described above, according to the substrate 1 of the present embodiment, a thick copper board can be formed since a circuit material is formed by pressing, and the substrate 1 that has high manufacturability and enables to resist high current can be obtained since an insulating part (a resin part) is formed by injection molding.

As described above, it is not necessary to fix a core part of a coil separately by such as a fixing member since at the coil 5, the core part 7 is formed to be one body with the injection molded circuit board 3 by core-forming resin containing magnetic filler.

As described above, as long as magnetic filler is an insulator, a core part can also be directly formed at the coil 5, and also, portions producing noise, such as an electronic component or a circuit, can be covered.

As described above, a resin part of the injection molded circuit board is not melted at the time of injection molding to the core part 7 since the melting temperature of substrate-forming resin is higher than that of core-forming resin.

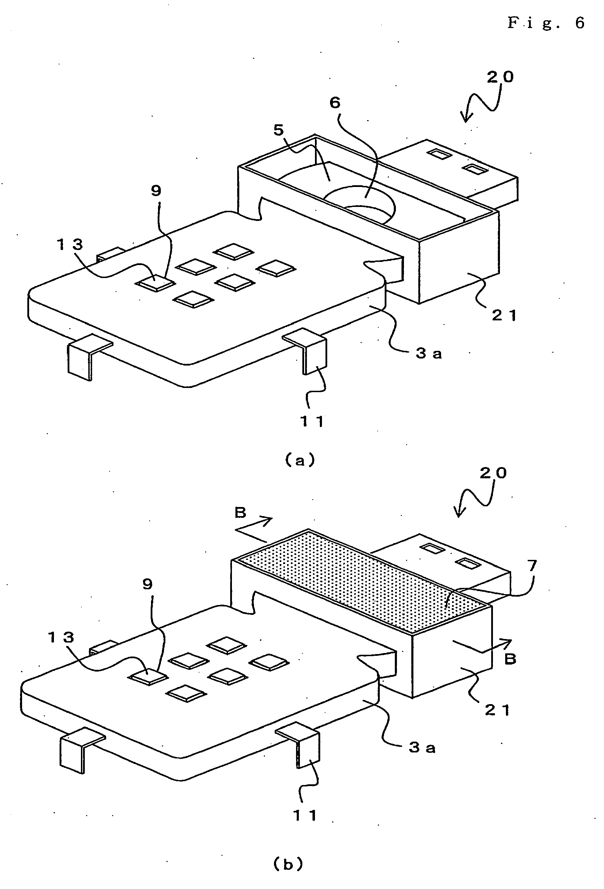

Next, a second embodiment will be described hereafter. Fig. 6 illustrates a substrate 20 according to the second embodiment. Fig. 6 (a) is a front side perspective view in which a condition before a core part is formed is illustrated, and Fig. 6 (b) is a front side perspective view in which a condition after a core part is formed is illustrated. In the following explanation, the same numerals as the ones used in Fig. 1 etc. are allotted to structural elements having similar functions as those of the substrate 1, and the explanations overlapping with each other will be omitted.

Although the substrate 20 has substantially the same structure as that of the substrate 1, there is a difference in an aspect near a coil 5 of an injection molded circuit board 3a. A case part 21 is formed at the substrate 20 so as to surround a periphery of a center core part 6 of the coil 5 (the entire part of the coil 5). The case part 21 is formed to be protruded toward both front and back sides of the injection molded circuit board 3a so as to surround all around the coil 5 (the center core part 6). The case part 21 is formed such that the width of the case part 21 is larger than that of the coil 5 (a coil part in a condition in which substrate-forming resin covers there) and side surfaces of the case 21 are formed continuously over a top and bottom surfaces of the coil 5.

As illustrated in Fig. 6 (a), the case part 21 is injection molded to be one body with a substrate part at the time of injection molding of the injection molded circuit board 3a. In this condition, core-forming resin is injected toward inside of the case part 21 to form a core part 7. In Fig. 6 (a), although an electronic component 13 has been installed thereon, it may be installed after the core part 7 is formed.

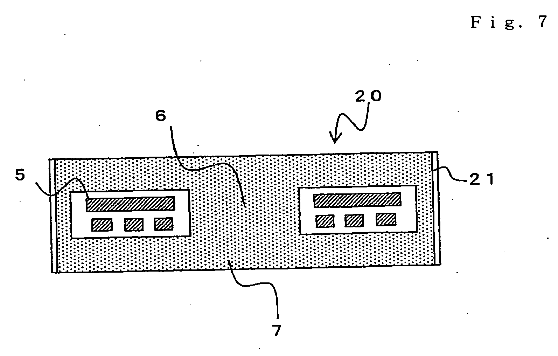

Fig. 7 is a B-B line sectional view of Fig. 6 (b). As illustrated in Fig. 7, the case part 21 is formed, against front and back directions, near the coil 5 so as to surround the coil 5. The core part 7 is formed inside of the case 21.

Although being explained that the case part 21 is formed to be one body with the injection molded circuit board 3a, it may be formed such that only the case part is formed as another body and then separately fixed to the injection molded circuit board. In this case, if the case part is made from resin, it is desirable for the melting temperature of resin which constitutes the case part 21 to be higher than that of core-forming resin which constitutes the core part 7.

According to the second embodiment, a similar effect as that of the first embodiment can be obtained. Additionally, the core part 7 does not rotate against the injection molded circuit board 3a since the core part 7 is formed inside of the case part 21. More specifically, for example in Fig. 5 (b), when force to rotate the core part 7 in a circumferential direction of the coil is applied, there is possibility that the core part 7 rotates against the injection molded circuit board (the coil). However, in the configuration with the case part 21, the possibility of rotation of the core part 7 will be reduced. Furthermore, it can be prevented that the core part 7 happens to be out of a front surface of the injection molded circuit board 3a.

Although the embodiments of the present invention have been described as the above referring to the drawings attached hereto, the technical scope of the present invention is not limited to the embodiments mentioned above. Apparently, a person skilled in the art is able to achieve other variations or modifications within a category of the technical ideas described in claims according to the present invention, and these variations and modifications will be considered to naturally belong to a technical scope of the present invention.

For example, in order to prevent rotation of the core part 7, concavo-convex may be provided on a surface near the coil part of the injection molded circuit board 3. Additionally, core-forming resin may be injected only inside of the center core part 6 in order not that the core part 7 is protruded from the injection molded circuit board. Furthermore, the injection molded circuit board of the portion for the core part to be formed may be arranged to be thin so that a surface of the substrate may become flat after the core part is formed.

The case part 21 is not necessarily a rectangle, but may be arranged in such as polygonal, ellipsoidal, or others various shape, and even if the center core part 6 is not surrounded completely, it is sufficient that a range of the portion for the core part to be formed is restricted by the core-forming mold.

### REFERENCE SIGNS LIST

- 1,20: Substrate
- 3,3a: Injection molded circuit board
- 5: Coil
- 6: Center core part
- 7: Core part
- 9: Electronic component mounting part
- 11: Connecting terminal
- 13: Electronic component
- 15: Circuit conductor
- 17a, 17b, 17c, 17d, 17e, 17f: Circuit material
- 21: Case part
- 100: Driver circuit
- 101: Motor controlling circuit
- 103: Motor
- 105: Power supply smoothing part
- 107: Switching element part
- 109: Choke coil

## Claims

1. A substrate comprising:
an injection molded circuit board having a coil part formed with a circuit conductor of which a surface is injection molded by substrate-forming resin; and
a core part being formed at least at a center core part of the coil part by injection of core-forming resin having magnetic filler.

2. The substrate according to claim 1, wherein a melting temperature of the substrate-forming resin is higher than a melting temperature of the core-forming resin.

3. The substrate according to claim 1, wherein the magnetic filler is insulating.

4. The substrate according to claim 1,
wherein the coil part of the injection molded circuit board has a case part being formed by the substrate-forming resin so as to surround the center core part of the coil part; and
wherein the core-forming resin is injected inside of the case part to form the core part.

5. The substrate according to claim 1, wherein a connecting terminal that is electronically connectable to outside is arranged to be protruded at a part of the substrate.

6. The substrate according to claim 1, wherein the substrate has a switching element and a circuit, for controlling a motor, that is formed with the circuit conductor.

7. A method of manufacturing a substrate comprising the steps of:
joining circuit materials that are conductors to form a circuit conductor having a coil part;
injecting substrate-forming resin toward a surface of the circuit conductor to mold an injection molded circuit board;
injecting core-forming resin that has magnetic filler and that has a lower melting point than that of the substrate-forming resin to mold a core part at least at a center core part of the coil part.

8. The method of manufacturing the substrate according to claim 7,
wherein the coil part of the injection molded circuit board has a case part being formed so as to surround the coil part; and
wherein the core-forming resin is injected inside of the case part to form a core.

9. The method of manufacturing the substrate according to claim 8, wherein the case part is injection molded to be one body with the injection molded circuit board by the substrate-forming resin.
